# FASCICULE DE BREVET EUROPEEN

(11) **EP 0 402 230 B1**
(45) Date de publication et mention de la délivrance du brevet: **24.08.1994**
(21) Numéro de dépôt: 90401509.6
(22) Date de dépôt: 05.06.1990
(51) Int. Cl.: H01L 23/544, H01L 21/00, H01L 21/304

(54) **Procédé et dispositif de marquage et de clivage de plaquettes de matériaux semiconducteurs monocristallins**
Verfahren und Vorrichtung zur Markierung und Spaltung von monokristallinen halbleitenden Plättchen
Process and device for marking and cleaving mono-crystalline semiconductor wafers

(30) Priorité: 07.06.1989 FR 8907537
(43) Date de publication de la demande: 12.12.1990
(73) Titulaire: COMMISSARIAT A L'ENERGIE ATOMIQUE, 75015 Paris Cédex 15 (FR)
(72) Inventeur: Petroz, Gérard, F-38330 Montbonnot Saint Martin (FR)
(74) Mandataire: Poulin, Gérard

(56) Documents cités:
- FR-A- 1 566 090
- FR-A- 2 046 933
- REVIEW OF THE ELECTRICAL COMMUNICATION LABORATORY, vol. 17, no. 9, septembre 1969, pages 1037-1055; I. IDA et al.: "Ultramicroscratching on worked GaAs surfaces"

## Description

La présente invention concerne un procédé et un dispositif de marquage et de clivage de plaquettes de matériaux semiconducteurs monocristallins.

Elle s'applique en particulier au marquage de directions de référence sur des plaquettes de matériaux semiconducteurs monocristallins de faible dureté ainsi qu'au clivage de telles plaquettes.

Par "faible dureté", on entend une dureté au plus égale à 500 unités KNOOP et par "forte dureté", on entend une dureté supérieure à 500 unités KNOOP.

On connaît déjà une technique de clivage de plaquettes monocristallines. Selon cette technique, pour cliver une telle plaquette monocristalline, on commence par tracer un trait, au moyen d'un diamant approprié, sur la face active, ou face avant, de la plaquette. Cette face est celle sur laquelle sont formés des composants semiconducteurs. Le trait peut être continu ou discontinu. Après avoir tracé ce trait, on met en oeuvre un procédé de déformation qui permet de casser la plaquette en deux suivant le trait tracé sur elle. A cet effet, la plaquette est placée sur un support mou et l'on passe un rouleau sur cette plaquette avec une pression adéquate pour obtenir la cassure. On notera que le clivage de plaquettes monocristallines suppose un repérage précis des plans de clivage. On sait que les plaquettes en silicium monocristallin sont pourvues d'un ou deux méplats à cet effet.

Cette technique connue de clivage a été développée essentiellement pour des matériaux tels que le silicium et l'arséniure de gallium, c'est-à-dire des matériaux de forte dureté. Des machines de clivage sont d'ailleurs commercialement disponibles et remplacent dans certains cas les machines de découpe à scie diamantée traditionnelles.

Il est à noter que des chemins de découpe, ou chemins de clivage, qui sont des zones non traitées, c'est-à-dire ne comportant aucun composant semiconducteur, sont prévus sur les plaquettes pour le traçage, sur chaque chemin, d'un trait permettant un clivage, de façon à ne pas endommager les composants semiconducteurs formés sur la plaquette. La largeur de ces chemins est de l'ordre de 100 micromètres, d'où une perte de place sur les plaquettes.

Par ailleurs, la technique de clivage classique qui consiste à tracer un trait sur une plaquette puis à cliver celle-ci par une méthode de déformation sur un support mou pour obtenir le clivage ne convient pas aux matériaux semiconducteurs de faible dureté, à cause des dégradations du réseau cristallin qui sont provoquées par cette déformation.

La présente invention a pour but de remédier aux inconvénients précédents, en proposant un procédé et un dispositif permettant de marquer des directions de référence sur des plaquettes de matériaux semiconducteurs monocristallins de faible dureté, et de cliver de telles plaquettes avec une grande précision qui autorise de prévoir sur lesdites plaquettes des chemins, ou zones, de clivage dont la largeur est nettement inférieure à 100 micromètre et peut être de l'ordre de 10 micromètres par exemple.

On connaît, par FR-A-1 566 090 (SIEMENS AG), un procédé pour séparer des composants semiconducteurs réalisés sur une même pastille cristalline sans altérer la qualité du cristal. Selon ce procédé, on divise la pastille cristalline par des traits constitués par des entailles gravées sur sa face arrière, suivant les frontières entre les différents composants semiconducteurs réalisés sur la pastille, après quoi on fragmente cette pastille par un procédé de séparation mécanique.

En outre on connaît, par FR-A-2 046 933, la technique de clivage classique pour cliver des plaquettes de spinelle.

De façon précise la présente invention a tout d'abord pour objet un procédé de marquage d'une direction de référence sur une plaquette d'un matériau semiconducteur monocristallin de faible dureté et de clivage de cette plaquette, procédé caractérisé en ce qu'il comprend les étapes suivantes :
- on forme une empreinte sur la face, dite face avant, de la plaquette, face sur laquelle sont, ou seront ultérieurement, formés des composants semiconducteurs, et dans une zone, dite zone non utile, de cette face avant, zone qui ne porte, ou ne portera ultérieurement, aucun desdits composants, l'empreinte mettant en évidence, sur cette zone non utile, au moins une direction dont on déduit la direction de référence,
- on marque cette direction de référence par un trait sur la zone non utile, et
- la direction de référence correspondant à une direction suivant laquelle on peut cliver la plaquette, on clive celle-ci en traçant un trait de clivage suivant la direction de référence, sur l'autre face, dite face arrière, de la plaquette et dans une zone de cette face arrière qui est située au-dessous de ladite zone non utile, de façon à cliver la plaquette dans cette zone non utile, prévue à cet effet.

En effet, on peut envisager de cliver la plaquette en traçant un trait de clivage suivant la direction de référence, dans la zone non utile, prévue à cet effet.

Cependant, le traçage d'un trait sur la plaquette induit des contraintes très importantes dans le matériau dont celle-ci est constituée et ces contraintes, qui sont localisées, provoquent la séparation de la plaquette en deux parties. Dans l'environnement immédiat, le réseau cristallin est perturbé, en particulier dans les matériaux monocristallins de faible dureté.

On voit donc que le traçage du trait de clivage non pas sur la face utile, ou face avant, de la plaquette mais sur la face opposée, ou face arrière, réduit au minimum les perturbations du réseau cristallin du côté de la face avant de la plaquette, sur laquelle se trouvent les composants semiconducteurs, puisque cette perturbation a lieu du côté de la face arrière et donc le plus loin possible de la face avant. Ceci permet de prévoir des chemins, ou zones, de clivage de faible largeur (moins de 100 micromètres, par exemple 10 micromètres) sur la face avant de la plaquette.

L'invention s'applique à des plaquettes faites de matériaux monocristallins pris dans le groupe comprenant CdTe, CdHgTe, InP, InSb, AlGaAs et plus généralement de matériaux semiconducteurs monocristallins de faible dureté, appartenant aux familles II-VI et III-V.

La direction mise en évidence par formation de l'empreinte peut être parallèle à des plans de glissement du matériau, ce matériau ayant des plans de clivage perpendiculaires à ces plans de glissement, la direction de référence choisie étant alors perpendiculaire à la direction mise en évidence par formation de l'empreinte.

L'empreinte peut être du genre de celles qui sont utilisées pour les tests de microdureté de matériaux.

La présente invention a également pour objet un dispositif de marquage d'une direction de référence sur une plaquette d'un matériau semiconducteur monocristallin de faible dureté et de clivage de cette plaquette, conformémant à la revendication 5.

Les moyens de formation d'empreinte et de traçage peuvent comprendre :
- des moyens de support de la plaquette, cette dernière reposant sur ces moyens de support par son autre face, dite face arrière, ces moyens de support étant mobiles en translation suivant un premier axe et un deuxième axe perpendiculaire au premier, lesdits moyens de support étant en outre mobiles en rotation autour d'un troisième axe, qui est perpendiculaire aux premier et deuxième axes, et mobiles en translation parallèlement à ce troisième axe,
- des moyens de maintien de la plaquette sur les moyens de support,
- des moyens d'observation microscopique de la face avant de la plaquette suivant un axe de visée qui est parallèle au troisième axe et qui est muni de moyens de repérage des premier et deuxième axes, ces moyens d'observation comportant au moins une optique d'observation microscopique, et
- un organe apte à former l'empreinte et apte à tracer le trait lorsque les moyens de support sont déplacés en translation suivant l'un des premier et deuxième axes.

Les moyens de supports peuvent comprendre un premier support mobile en translation, suivant les premier, deuxième et troisième axes et un second support qui est mobile en rotation autour du troisième axe, qui est monté sur le premier support et qui porte les moyens de maintien de la plaquette.

L'organe apte à former l'empreinte et à tracer le trait peut être rendu solidaire de l'optique d'observation, l'ensemble formé par cet organe et cette optique étant mobile de telle façon que l'on puisse placer alternativement l'optique d'observation et l'organe suivant l'axe de visée.

Les moyens aptes à tracer un trait de clivage peuvent comprendre un organe de traçage qui est disposé au-dessous desdits moyens de support et qui est mobile en translation parallèlement aux premier, deuxième et troisième axes, les moyens de support comportant un perçage permettant le passage de l'organe de traçage et les moyens de maintien de la plaquette étant aptes à empêcher le soulèvement de celle-ci lorsque l'organe de traçage appuie contre elle.

L'axe de visée peut être en outre muni de moyens de repérage d'au moins une direction de clivage.

Enfin, pour des questions d'homogénéité de pression, l'organe apte à former l'empreinte et à tracer le trait est de préférence prévu pour former un impact de forme sphérique sur la plaquette.

On voit donc que la présente invention permet, au moyen d'un même dispositif, de repérer des directions cristallographiques, de marquer des directions de référence en vue d'un traitement ultérieur de plaquettes de matériaux semiconducteurs monocristallins de faible dureté et de cliver de telles plaquettes. Comme on le verra par la suite, le dispositif objet de l'invention, muni des moyens aptes à tracer un trait de clivage sur la face arrière de la plaquette, permet également de cliver des matériaux semiconducteurs monocristallins de forte dureté, tels que Si et AsGa.

La présente invention sera mieux comprise à la lecture de la description suivante d'exemples de réalisation donnés à titre purement indicatif ou nullement limitatif, en référence aux dessins annexés sur lesquels :
- les figures 1A et 1B illustrent schématiquement des empreintes que l'on réalise conformément à l'invention et qui sont du genre de celles qui sont utilisées pour les tests de microdureté respectivement de type VICKERS et de type ROCKWELL,
- la figure 2 est une vue schématique d'un dispositif utilisable dans l'invention,
- les figures 3 et 4 sont des vues schématiques d'exemples de réalisation d'un organe de marquage qui est utilisable dans le dispositif représenté sur la figure 2,
- la figure 5 illustre schématiquement une étape d'un procédé de marquage conforme à l'invention, mis en oeuvre dans le dispositif représenté sur la figure 2,
- la figure 6 est une vue schématique de moyens de clivage dont on munit le dispositif représenté sur la figure 2, pour la mise en oeuvre de l'invention,
- la figure 7 est une vue schématique d'un exemple de moyens de maintien de la plaquette dans le dispositif représenté sur la figure 2,
- la figure 8 illustre schématiquement une plaquette qui comporte des chemins de clivage et qui peut être clivée grâce aux moyens représentés sur la figure 6,
- la figure 9 illustre schématiquement des moyens de repérage de directions de clivage, dont peut être muni le dispositif représenté sur la figure 2, et
- la figure 10 illustre schématiquement une plaquette d'un matériau semiconducteur monocristallin de forte dureté, qui est munie de chemins de clivage et peut être clivée grâce aux moyens représentés sur la figure 6, dans le dispositif représenté sur la figure 2.

On va décrire dans ce qui suit un mode de réalisation particulier du dispositif objet de l'invention. On précise que ce dispositif peut être réalisé à partir d'un microscope optique classique à lumière transmise, convenablement modifié, ou plus généralement, à partir de tout système d'observation microscopique, équipé de moyens de translation-rotation.

Conformément au procédé objet de l'invention, pour marquer une direction de référence sur une plaquette d'un matériau semiconducteur monocristallin de faible dureté, on commence par former une empreinte sur la face avant de la plaquette et dans une zone non utile de cette face avant. Cette empreinte est du genre de celles qui sont utilisées dans les tests de microdureté et provoque une déformation du réseau environnant, déformation qui révèle des plans cristallographiques ou des micro-amorces de clivage, à partir desquels on peut déterminer une direction de référence sur la plaquette, comme on le verra par la suite.

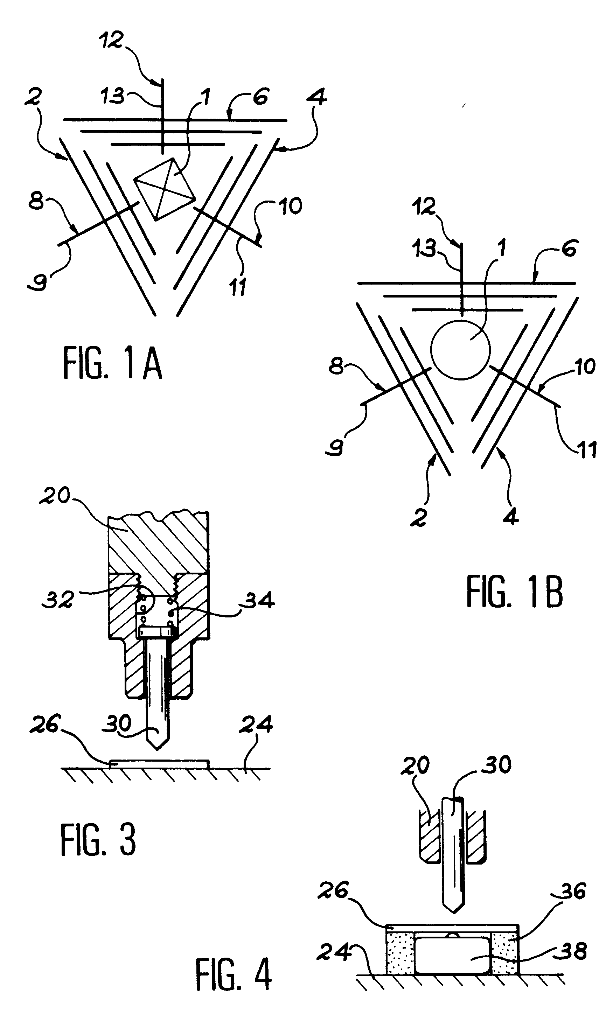

Les figures 1A et 1B illustrent de telles empreintes 1. Sur ces figures, ces empreintes 1 sont supposées formées dans des matériaux de type CdHgTe ou CdTe-111. La formation d'une empreinte met en évidence, à la surface de la plaquette, des groupes de plans de glissement de type 110. Ces groupes portent les références 2, 4, 6 sur les figures 1A et 1B. Chaque plan d'un groupe fait un angle de 60° avec un plan d'un autre groupe. Une direction de référence, que l'on veut marquer sur la plaquette, est la trace, à la surface de celle-ci, d'un plan de clivage. Les plans de clivage, de type 110, sont perpendiculaires à la surface de la plaquette et sont également perpendiculaires aux plans qui ont glissé près de l'impact créant l'empreinte. Ces plans qui ont glissé, de type 110, sont à environ 35° de la surface de la plaquette. On a représenté sur les figures 1A et 1B des plans de clivage qui portent les références 8, 10, 12 et qui sont respectivement perpendiculaires aux groupes de plans 2, 4, 6. Les directions de référence, qui portent les références 9, 11, 13, sont respectivement parallèles aux plans 8, 10, 12 et, dans les exemples des figures 1A et 1B, passent par le centre de l'empreinte.

Pour former une empreinte, on peut utiliser une pointe à diamant de forme pyramidale ou conique utilisée dans les tests de type VICKERS (figure 1A) mais, pour des raisons d'homogénéité de pression, il est préférable d'utiliser une pointe à diamant de forme sphérique, utilisée dans les tests de type ROCKWELL (figure 1B).

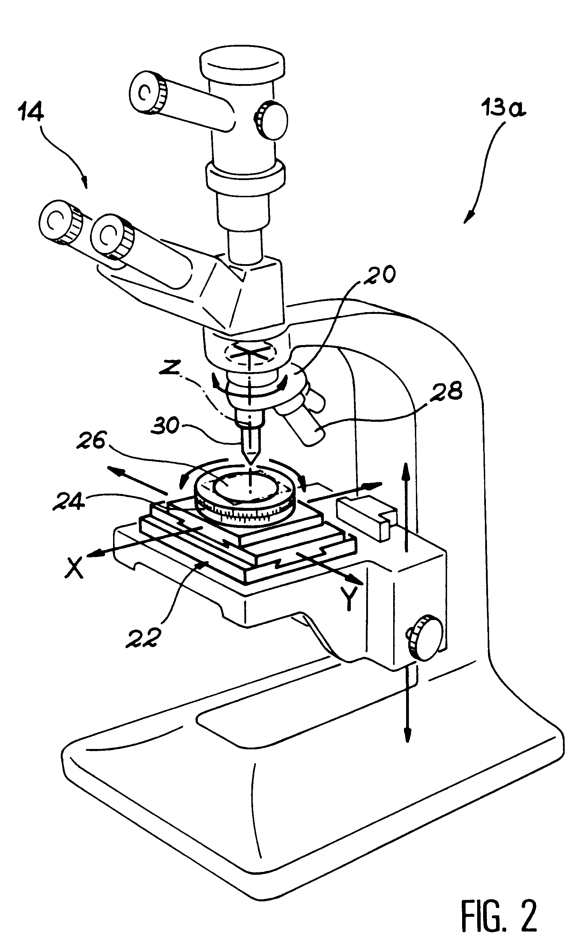

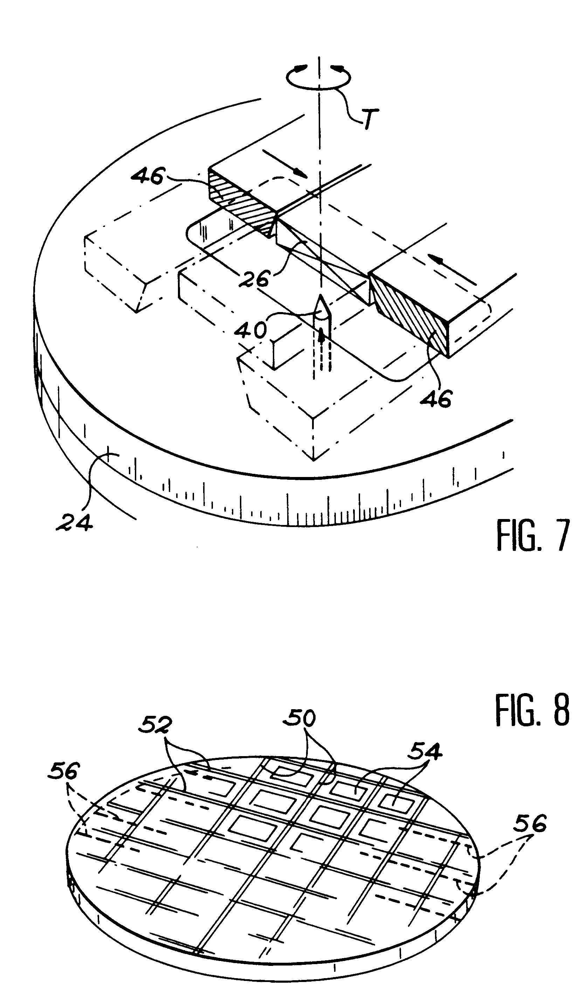

Le dispositif utilisable dans l'invention, qui est schématiquement représenté sur la figure 2, comporte un microscope optique classique 13a. Ce microscope comprend au moins un oculaire 14 muni d'un réticule 16 (voir figure 5) en forme de croix dont les deux branches définissent respectivement des axes X et Y perpendiculaires. Le microscope comporte un axe de visée Z qui est perpendiculaire aux axes X, Y et qui passe par le centre du réticule. Le microscope comporte en outre un ensemble-support 22, qui est appelé plus simplement platine 22 dans ce qui suit et qui est déplaçable en translation suivant les axes X, Y et Z et situé au-dessous de la tourelle 20 du microscope. Pour la mise en oeuvre de l'invention, on ajoute au microscope 13a une platine 24 qui est montée sur la platine 22 et qui est mobile en rotation sur celle-ci, autour d'un axe T (voir figure 7) qui est parallèle à l'axe Z. C'est sur cette platine 24 que l'on fixe une plaquette 26 que l'on veut marquer conformément à l'invention.

Par ailleurs, la tourelle 20 porte normalement plusieurs objectifs 28 de grossissement. Cependant, pour la mise en oeuvre de l'invention, l'un de ces objectifs est remplacé par une pointe à diamant 30 servant à former l'empreinte dans la plaquette. Les objectifs 28 qui restent ont différents grossissement, par exemple x5, x10, x20 et x50 respectivement. La tourelle 20 est mobile en rotation de telle façon que l'on puisse amener, au choix, l'un des objectifs ou la pointe à diamant dans l'axe de visée Z, l'axe optique de cet objectif ou l'axe de la pointe à diamant coïncidant alors avec cet axe de visée Z.

De plus, comme on le voit sur la figure 3, la tourelle est modifiée pour permettre une translation de la pointe à diamant 30 parallèlement à l'axe de visée Z lorsque cette pointe à diamant se trouve placée suivant cet axe de visée Z. A cet effet, un logement approprié 32 est prévu dans la tourelle 20 et la pointe à diamant 30 est mobile en translation dans ce logement 32. Comme on le verra par la suite, on exerce au moyen de la pointe à diamant 30 une pression déterminée sur la plaquette. Pour ce faire, on place dans le logement 32 un ressort approprié 34 qui appuie d'un côté contre le fond du logement 32 et de l'autre contre l'extrémité de la pointe 30 opposée à celle qui porte le diamant. Comme on le voit sur la figure 3, le logement 32 comporte un épaulement interne contre lequel appuie ladite extrémité, cette dernière étant plus large que le reste de la pointe 30. On peut ainsi exercer une pression calibrée. Dans une variante non représentée, la pression est contrôlée au moyen d'un capteur de force.

Dans une autre variante de réalisation schématiquement illustrée par la figure 4, la pointe à diamant 30 reste fixe par rapport à la tourelle 20 et la plaquette 26 est montée sur la platine 24 par l'intermédiaire d'un support élastique 36 et la pression exercée par la pointe à diamant 30 est contrôlée par un capteur de force 38 qui est interposé entre la plaquette 26 et la platine 24.

A cet effet, le support élastique 36 peut comporter un perçage, le capteur de force 38 étant placé sur la platine 24 à l'intérieur de ce perçage, la partie du capteur 38, qui est sensible à la force, étant bien entendu en contact avec la plaquette 26.

Bien entendu, dans le cas de l'emploi d'un capteur de force, on prévoit des moyens non représentés pour avertir l'utilisateur du dispositif que la pression à ne pas dépasser est atteinte.

On va maintenant expliquer comment on forme l'empreinte dans la plaquette. Cette plaquette étant mise en place et maintenue sur la platine 24, la face arrière de la plaquette étant tournée vers cette dernière, on observe la face avant de cette plaquette au moyen d'un objectif approprié 28 de la tourelle 20 et l'on déplace la platine 22 par des translations appropriées suivant les axes X et Y de façon à observer suivant l'axe Z une zone non utile de la face avant de la plaquette 26, dans laquelle on veut former l'empreinte. On tourne alors la tourelle 20 de façon à disposer la pointe à diamant 30 suivant l'axe Z et l'on déplace la platine 22 en translation suivant l'axe Z de façon à faire monter la plaquette 26, jusqu'à ce que l'empreinte voulue soit formée.

On obtient alors une empreinte qui est par exemple du genre de celle qui est représentée sur la figure 1A ou la figure 1B. Il est ensuite possible de marquer une direction de référence (du genre des directions 9, 11, 13) sur la zone non utile de la plaquette, prévue à cet effet. Pour ce faire, on rabaisse la platine 22, on fait tourner la tourelle pour remettre en place l'objectif 28 suivant l'axe de visée Z, et, en supposant que la zone non utile soit un chemin parallèle à l'axe X (repéré par le réticule 16), on fait tourner la platine 24 de façon à rendre les plans de l'une des famille 2, 4, 6 parallèles à l'axe Y (repéré par le réticule 16) de façon que les plans de clivage soient parallèles à l'axe X et que la direction de référence choisie, par exemple la direction 13 correspondant au plan de clivage 12, vienne coïncider avec l'axe X du réticule 16, cette direction étant la médiatrice commune aux segments matérialisant les plans de glissement 4 correspondants. Ensuite, on utilise la pointe à diamant 30 pour marquer la direction de référence. A cet effet, on remet la pointe à diamant 30 en place suivant l'axe de visée Z, par rotation de la tourelle 20, on remonte la platine 22 à sa position précédente et l'on effectue une translation de la platine 22, et donc de la plaquette 26, suivant l'axe X. La direction de référence est ainsi marquée par un trait dans la zone non utile.

Cette direction de référence peut être utilisée comme référence de positionnement de masques ou pour cliver la plaquette, sur la face avant de celle-ci, suivant la direction ainsi marquée. A cet effet, on utilise encore la pointe à diamant 30 pour tracer un trait de clivage suivant la direction de référence marquée, en déplaçant encore la platine 22 en translation suivant l'axe X, d'où la séparation de la plaquette 26 en deux parties.

Comme on l'a déjà indiqué, un clivage de la plaquette sur la face avant de celle-ci nécessite de prévoir des chemins de découpe de largeur importante, du fait de la perturbation induite par le clivage sur la face de la plaquette qui porte des composants semiconducteurs. C'est pourquoi, conformément à l'invention, on clive la plaquette par la face arrière de celle-ci. A cet effet, le microscope que l'on utilise est muni de moyens supplémentaires que l'on va décrire. On indique que le clivage peut être obtenu par traçage d'un trait continu ou discontinu sur la face arrière de la plaquette parallèlement aux plans de clivage et dans une zone appropriée de cette face arrière. L'outil de clivage peut comporter un diamant de découpe à titre indicatif mais non limitatif. L'intérêt d'un tel diamant réside dans la qualité de son arête, sa dureté et sa résistance à l'usure.

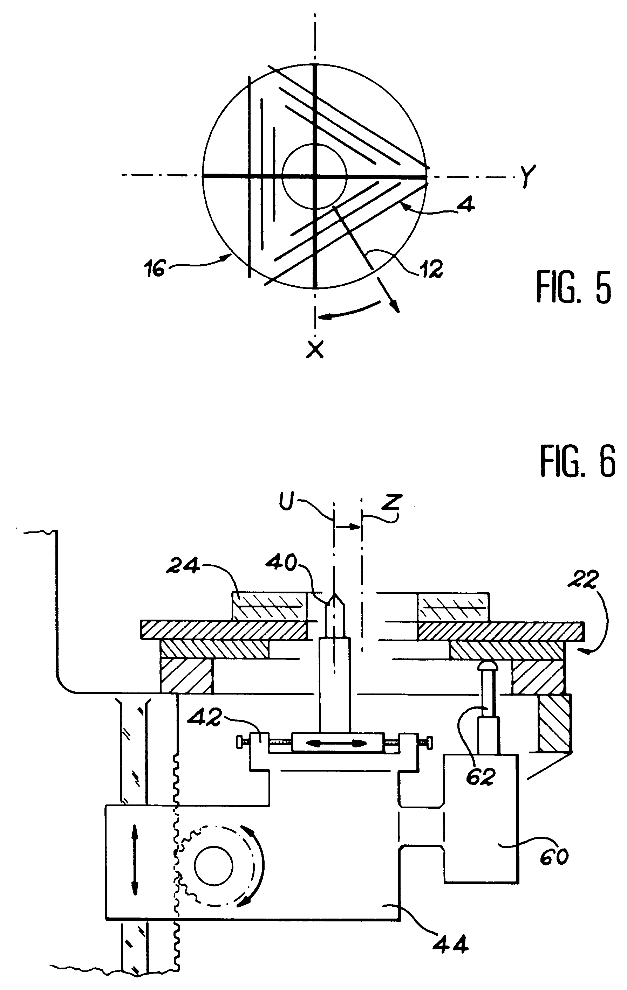

Afin de cliver la plaquette par la face arrière de celle-ci, on munit ainsi le microscope du dispositif représenté sur la figure 2 d'une pointe à diamant de découpe 40 (figure 6) dont l'axe U est parallèle à l'axe Z et qui se trouve en-dessous de la platine 22. Cette pointe à diamant 40 est montée sur une première platine 42 qui permet le déplacement de la pointe 40 en translation suivant les axes X et Y. Cette platine 42 est elle-même montée sur une autre platine 44 qui est déplaçable en translation parallèlement à l'axe Z. De plus, l'ensemble des platines 22, 24 comporte un perçage central dont l'axe est parallèle à l'axe Z et dont la taille (le diamètre dans le cas d'un perçage circulaire) est suffisante pour permettre le passage de la pointe à diamant 40 et pour permettre des déplacements de cette pointe 40 suivant les axes X et Y pour le positionnement convenable de cette pointe 40 et le traçage du trait de clivage.

La platine 24 utilisée dans le dispositif représenté sur la figure 2 peut tourner de 360° sur elle-même et comporte un réglage fin par vernier de précision de 1 minute d'angle.

Sur la figure 7, on a représenté schématiquement les moyens de maintien de l'échantillon 26 sur la platine 24. Il s'agit de brides de serrage 46 qui maintiennent la plaquette 26 en appuyant sur les arêtes de la face avant de celle-ci. Cette face avant n'est ainsi en contact avec aucun support. Dans l'exemple représenté sur la figure 7, la plaquette 26 a une forme rectangulaire et le perçage des platines a également une forme rectangulaire. On utilise deux brides de serrage 46 qui appuient respectivement sur deux côtés de la plaquette qui sont parallèles à deux côtés du perçage. La plaquette repose par ses deux autres côtés sur la platine 24.

On voit en outre que les moyens de serrage sont prévus poue empêcher le soulèvement de la plaquette 26 au cours du traçage du trait de clivage sur la face arrière de la plaquette, les faces des extrémités des brides 46, qui viennent contre les arêtes de la face avant de la plaquette, étant inclinées vers le haut.

On va maintenant expliquer comment on clive une plaquette par la face arrière de celle-ci. Sur la figure 8, on a représenté schématiquement une plaquette à cliver qui a par exemple une forme circulaire. On voit sur la face avant de celle-ci des chemins de clivage 50 qui sont parallèles les uns aux autres. Il peut exister d'autres chemins de clivage 52 parallèles les uns aux autres et perpendiculaires aux chemins 50. Dans les zones de la face avant de la plaquette, qui sont délimitées par les croisements des chemins, se trouvent des composants semiconducteurs 54 que l'on veut justement séparer les uns des autres par clivage de la plaquette suivant les différents chemins.

Pour ce faire, on tracera des traits de clivage 56 sur la face arrière de la plaquette et au-dessous des différents chemins.

On va maintenant expliquer comment faire un trait de clivage sur la face arrière de la plaquette, en-dessous d'un chemin de clivage qui a été prévu sur la face avant de cette plaquette. On précise à ce propos que le support élastique qui a été décrit en référence à la figure 4 et qui peut être utilisé pour former une empreinte et tracer une direction de référence sur la face avant de la plaquette ne convient pas pour tracer le trait de clivage. Donc, si l'on a utilisé préalablement ce support élastique associé au capteur 38, on démonte cet ensemble et l'on met en place sur la platine 24 des moyens de serrage de la plaquette, par exemple du genre de ceux qui ont été décrits en se référant à la figure 7.

Un objectif 28 de la tourelle 20 étant disposé suivant l'axe de visée Z, on commence par faire des translations de la platine 42 portant la pointe à diamant 40 de façon que l'axe U de cette pointe 40 soit confondu avec l'axe de visée Z, le diamant se trouvant ainsi sur cet axe de visée.

On précise en outre qu'avant de cliver la plaquette, on vérifie le parallélisme du réticule et du futur trait en traçant un trait sur un échantillon d'essai puis qui en "alignant" le réticule 16 (supposé mobile en rotation autour de l'axe Z) sur ce trait d'essai.

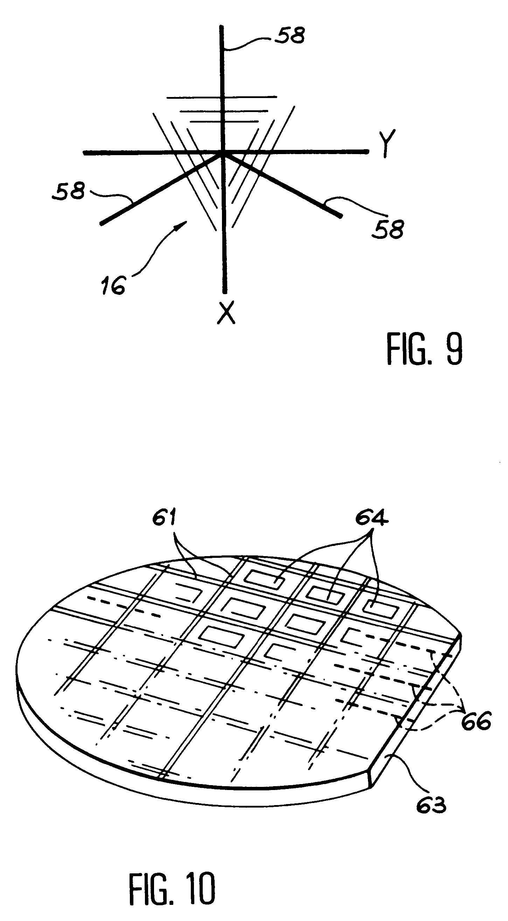

On peut d'ailleurs munir le réticule 16 de références pour le marquage d'une direction de clivage. Dans le cas de l'exemple représenté sur les figures 1A et 1B, de telles références peuvent consister en trois traits 58 qui sont à 120° les uns des autres et se rencontrent au centre de la croix du réticule 16 (pour des matériaux monocristallins de type 111), l'un des traits 58 étant confondu avec l'axe X du réticule, comme on le voit sur la figure 9.

On précise en outre que le dispositif est muni d'un capteur de déplacement ou de force 60 qui est rendu rigidement solidaire de la platine 44 (figure 6) et qui est prévu pour contrôler les conditions de traçage sur la plaquette. La partie sensible 62 de ce capteur 60 vient appuyer contre la platine 22 lorsque l'on fait monter la platine 44, le capteur 60 étant réglé pour fournir alors un signal qui avertit l'utilisateur qu'une pression suffisante est exercée par la pointe à diamant 40 contre la face arrière de la plaquette. On peut choisir un capteur 60 apte à détecter des déplacements à ± 1 micromètre près.

Pour tracer le trait de clivage, on procède donc de la façon suivante : on met en place la plaquette sur la platine 24 sur laquelle on la maintient grâce aux brides 46, la face arrière de la plaquette étant bien entendu contre la platine 24. On observe, au moyen de l'objectif 28 de la tourelle, le chemin suivant lequel on veut cliver la plaquette (en sachant que le diamant de la pointe 40 se trouve sur l'axe de visée Z). En utilisant des translations appropriées de la platine 22 parallèlement aux axes X et Y et une rotation appropriée de la platine 24 autour de l'axe T, on oriente le chemin en question de façon que l'axe X du réticule 16 soit placé sensiblement suivant la ligne médiane de ce chemin et que le centre du réticule se trouve à une extrémité dudit chemin. On monte alors la platine 44 jusqu'à ce que le diamant de la pointe 40 excerce une pression suffisante sur la face arrière de la plaquette puis l'on déplace en translation celle-ci suivant l'axe X en déplaçant la platine 22 en translation suivant cet axe X de façon que le trait de clivage soit tracé le long dudit chemin, la plaquette étant ainsi clivée. Le contrôle visuel de la face avant en cours de traçage sur la face arrière permet d'arrêter ce traçage dès que le clivage est visualisé.

On notera que les performances du dispositif sont liées à la précision mécanique des déplacements parallèlement aux axes X, Y et Z. A titre d'exemple, le dispositif que l'on vient de décrire en se référant aux figures et qui est adapté sur un microscope, permet, à partir de barrette de CdTe de 2,5 millimètres de largeur et 400 micromètres d'épaisseur, d'obtenir des barrettes clivées de 150 micromètres de largeur.

La présente invention permet de cliver des matériaux semiconducteurs monocristallins de faible dureté ainsi que des couches minces de tels matériaux, formées sur des substrats également faits de ces matériaux, et également de cliver des échantillons de tels matériaux pour les observer par microscopie électronique.

De par sa précision, le procédé objet de l'invention permet de juxtaposer, après clivage, des circuits intégrés en conservant le pas d'implantation des éléments actifs de ceux-ci.

Le dispositif objet de l'invention permet également de cliver, par la face arrière, des plaquettes de matériaux semiconducteurs monocristallins de forte dureté, tels que le silicium, avec une précision de positionnement de quelques micromètres. On voit sur la figure 10 une telle plaquette qui est munie d'un réseau de chemins de découpe 61 sur sa face avant et d'au moins un méplat parallèle à des chemins 61, de façon connue. Les chemins 61 délimitent des zones dans lesquelles sont formées des composants semiconducteurs 64. Le clivage suivant l'un des chemins 61 est réalisé par traçage, au moyen d'un diamant par exemple, d'un trait de clivage sur la face arrière de la plaquette et suivant un trait 66 situé au-dessous du chemin considéré, après quoi la plaquette est cassée en deux sur un support mou par l'intermédiaire d'un rouleau par exemple.

## Revendications

1. Procédé de marquage d'une direction de référence sur une plaquette d'un matériau semiconducteur monocristallin ayant une dureté au plus égale à 500 unités KNOOP et de clivage de cette plaquette, procédé comprenant les étapes suivantes :
- on forme une empreinte (1) sur la face, dite face avant, de la plaquette (26), face sur laquelle sont, ou seront ultérieurement, formés des composants semiconducteurs (54), et dans une zone (52), dite zone non utile, de cette face avant, zone qui ne porte, ou ne portera ultérieurement, aucun desdits composants, l'empreinte mettant en évidence, sur cette zone non utile, au moins une direction dont on déduit la direction de référence (9, 11, 13),
- on marque cette direction de référence par un trait sur la zone non utile, et
- la direction de référence (9, 11, 13) correspondant à une direction suivant laquelle on peut cliver la plaquette, on clive celle-ci en traçant un trait de clivage suivant la direction de référence, sur l'autre face, dite face arrière, de la plaquette et dans une zone de cette face arrière qui est située au-dessous de ladite zone non utile, de façon à cliver la plaquette dans cette zone non utile, prévue à cet effet.

2. Procédé selon la revendication 1, caractérisé en ce que la plaquette est faite d'un matériau monocristallin pris dans le groupe comprenant CdTe, CdHgTe, InP, InSb, AlGaAs.

3. Procédé selon l'une quelconque des revendications 1 et 2, caractérisé en ce que la direction mise en évidence par formation de l'empreinte est parallèle à des plans de glissement (2, 4, 6) du matériau, ce matériau ayant des plans de clivage (8, 10, 12) perpendiculaires à ces plans de glissement, et en ce que la direction de référence est perpendiculaire à la direction mise en évidence par formation de l'empreinte.

4. Procédé selon l'une quelconque des revendications 1 à 3, caractérisé en ce que l'empreinte est formée par un organe du genre de ceux qui sont utilisés pour les tests de microdureté de matériaux.

5. Dispositif de marquage d'une direction de référence sur une plaquette (26) d'un matériau semiconducteur monocristallin de dureté au plus égale à 500 unités KNOOP et de clivage de cette plaquette, la direction de référence (9, 11, 13) correspondant à une direction suivant laquelle on peut cliver la plaquette, dispositif comprenant des moyens (13a, 22, 24, 30) de formation d'empreinte et de traçage, prévus
- pour la formation d'une empreinte sur une face, dite face avant, de la plaquette, face sur laquelle sont, ou seront ultérieurement, formés des composants semiconducteurs (54), et dans une zone (52), dite zone non utile, de cette face avant, zone qui ne porte, ou ne portera ultérieurement, aucun desdits composants, l'empreinte mettant en évidence, sur cette zone non utile, au moins une direction dont on déduit la direction de référence, et
- pour le traçage, sur la zone non utile, d'un trait prévu pour marquer cette direction de référence,
et ce dispositif comprenant en outre des moyens (40, 42, 44) aptes à tracer un trait de clivage suivant la direction de référence, sur l'autre face, dite face arrière, de la plaquette et dans une zone de cette face arrière qui est située au-dessous de ladite zone non utile, de façon à cliver la plaquette dans cette zone non utile, prévue à cet effet.

6. Dispositif selon la revendication 5, caractérisé en ce que les moyens de formation d'empreinte et de traçage comprennent :
- des moyens (22, 24) de support de la plaquette (26), cette dernière reposant sur ces moyens de support par la face arrière, ces moyens de support étant mobiles en translation suivant un premier axe (X) et un deuxième axe (Y) perpendiculaire au premier, lesdits moyens de support étant en outre mobiles en rotation autour d'un troisième axe (T), qui est perpendiculaire aux premier et deuxième axes, et mobiles en translation parallèlement à ce troisième axe,
- des moyens (46) de maintien de la plaquette sur les moyens de support,
- des moyens (13a) d'observation microscopique de la face avant de la plaquette suivant un axe de visée (Z) qui est parallèle au troisième axe (T) et qui est muni de moyens (16) de repérage des premier et deuxième axes, ces moyens d'observation comportant au moins une optique (28) d'observation microscopique, et
- un organe (30) apte à former l'empreinte et apte à tracer le trait lorsque les moyens de support sont déplacés en translation suivant l'un des premier et deuxième axes.

7. Dispositif selon la revendication 6, caractérisé en ce que les moyens de support comprennent un premier support (22) mobile en translation, suivant les premier, deuxième et troisième axes et un second support (24) qui est mobile en rotation autour du troisième axe, qui est monté sur le premier support et qui porte les moyens (46) de maintien de la plaquette.

8. Dispositif selon l'une quelconque des revendications 6 et 7, caractérisé en ce que l'organe (30) apte à former l'empreinte et à tracer le trait est rendu solidaire de l'optique d'observation (28), l'ensemble formé par cet organe et cette optique étant mobile de telle façon que l'on puisse placer alternativement l'optique d'observation et l'organe suivant l'axe de visée (Z).

9. Dispositif selon l'une quelconque des revendications 6 à 8, caractérisé en ce que les moyens aptes à tracer un trait de clivage comprennent un organe de traçage (40) qui est disposé au-dessous desdits moyens de support (22, 24) et qui est mobile en translation parallèlement aux premier (X), deuxième (Y) et troisième axes, en ce que les moyens de support comportent un perçage permettant le passage de l'organe de traçage et en ce que les moyens (46) de maintien de la plaquette sont aptes à empêcher le soulèvement de celle-ci lorsque l'organe de traçage appuie contre elle.

10. Dispositif selon l'une quelconque des revendications 5 à 9, caractérisé en ce que l'axe de visée (Z) est en outre muni de moyens (58) de repérage d'au moins une direction de clivage.

11. Dispositif selon l'une quelconque des revendications 6 à 9, caractérisé en ce que l'organe (30) apte à former l'empreinte et à tracer le trait est prévu pour former un impact de forme sphérique sur la plaquette.

## Patentansprüche

1. Verfahren zur Markierung einer Bezugsrichtung auf einem Plättchen eines monokristallinen Halbleitermaterials, welches eine Härte von höchstens 500 Knoop-Einheiten hat, und zur Spaltung dieses Plättchens, wobei das Verfahren die folgenden Schritte umfaßt:
- Man erzeugt einen Eindruck (1) auf der als Vorderseite bezeichneten Seite des Plättchens (26), der Seite, auf der Halbleiter-Bauelemente (54) ausgebildet sind oder später ausgebildet werden, und in einem Bereich (52) dieser Vorderseite, der als nicht nutzbarer Bereich bezeichnet wird, einem Bereich, der keines der genannten Bauelemente trägt oder später tragen wird, wobei der Eindruck auf diesem nicht nutzbaren Bereich zumindest eine Richtung hervorhebt, aus der man die Bezugsrichtung (9, 11, 13) ableitet,
- man markiert diese Bezugsrichtung mit einem Strich auf dem nicht nutzbaren Bereich und,
- wenn die Bezugsrichtung (9, 11, 13) einer Richtung entspricht, in der man das Plättchen spalten kann, spaltet man dieses, indem man auf der anderen, als Rückseite bezeichneten Seite des Plättchens und in einem Bereich dieser Rückseite, der unter dem genannten nicht nutzbaren Bereich liegt, entsprechend der Bezugsrichtung einen Strich zur Spaltung anreißt, um das Plättchen in diesem nicht nutzbaren Bereich, der für diesen Zweck vorgesehen ist, zu spalten.

2. Verfahren nach Anspruch 1, dadurch gekennzeichnet, daß das Plättchen aus einem monokristallinen Material hergestellt ist, das in der Gruppe gewählt ist, die CdTe, CdHgTe, InP, InSb und AlGaAs umfaßt.

3. Verfahren nach einem der Ansprüche 1 und 2, dadurch gekennzeichnet, daß die durch Erzeugen des Eindrucks hervorgehobene Richtung parallel zu Gleitebenen (2, 4, 6) des Materials ist, wobei dieses Material Spaltungsebenen (8, 10, 12) hat, die senkrecht zu diesen Gleitebenen sind, und daß die Bezugsrichtung senkrecht zu der durch Erzeugung des Eindrucks hervorgehobenen Richtung ist.

4. Verfahren nach einem der Ansprüche 1 bis 3, dadurch gekennzeichnet, daß der Eindruck erzeugt wird mit einem Werkzeug nach Art der Werkzeuge, die für die Prüfungen der Mikrohärte von Materialien verwendet werden.

5. Vorrichtung zur Markierung einer Bezugsrichtung auf einem Plättchen (26) eines monokristallinen Halbleitermaterials geringer Härte und zur Spaltung dieses Plättchens, wobei die Bezugsrichtung (9, 11, 13) einer Richtung entspricht, in der man das Plättchen spalten kann, wobei die Vorrichtung Einrichtungen (13a, 22, 24, 30) zu Erzeugung eines Eindrucks und zum Anreißen umfaßt, die vorgesehen sind
- zur Erzeugung eines Eindrucks auf einer als Vorderseite bezeichneten Seite des Plättchens, der Seite, auf der Halbleiter-Bauelemente (54) ausgebildet sind oder später ausgebildet werden, und in einem Bereich (52) dieser Vorderseite, der als nicht nutzbarer Bereich bezeichnet wird, einem Bereich, der keines der genannten Bauelemente trägt oder später tragen wird, wobei der Eindruck auf diesem nicht nutzbaren Bereich zumindest eine Richtung hervorhebt, aus der man die Bezugsrichtung ableitet, und
- zum Anreißen eines Strichs, der dazu vorgesehen ist, diese Bezugsrichtung zu markieren, auf dem nicht nutzbaren Bereich,
wobei diese Vorrichtung ferner Einrichtungen (40, 42, 44) umfaßt, die geeignet sind, auf der anderen, als Rückseite bezeichneten Seite des Plättchens und in einem Bereich dieser Rückseite, der unter dem genannten nicht nutzbaren Bereich liegt, einen Strich zur Spaltung in der Bezugsrichtung anzureißen, um das Plättchen in diesem nicht nutzbaren Bereich, der für diesen Zweck vorgesehen ist, zu spalten.

6. Vorrichtung nach Anspruch 5, dadurch gekennzeichnet, daß die Einrichtungen zur Erzeugung eines Eindrucks und zum Anreißen umfassen:
- Trageeinrichtungen (22, 24) für das Plättchen (26), wobei dieses mit der Rückseite auf den Trageeinrichtungen aufliegt, während die Trageeinrichtungen nach einer ersten Achse (X) und einer zweiten, zur ersten senkrechten Achse (Y) verschiebbar sind und diese Trageeinrichtungen ferner um eine dritte Achse (T), welche senkrecht zur ersten und zur zweiten Achse ist, drehbar sind und parallel zu dieser dritten Achse verschiebbar sind,
- Einrichtungen (46) zum Festhalten des Plättchens auf den Trageeinrichtungen,
- Einrichtungen (13a) zur mikroskopischen Beobachtung der Vorderseite des Plättchens in einer Ziellinie (Z), die parallel zur dritten Achse (T) ist und die mit Einrichtungen (16) zum Bestimmen der ersten und zweiten Achse versehen ist, wobei diese Einrichtungen zur Beobachtung mindestens eine Optik (28) zur mikroskopischen Beobachtung umfassen, und
- ein Werkzeug (30), das geeignet ist, den Eindruck zu erzeugen und den Strich anzureißen, wenn die Trageeinrichtungen nach einer der ersten und zweiten Achse verschoben werden.

7. Vorrichtung nach Anspruch 6, dadurch gekennzeichnet, daß die Trageeinrichtungen einen ersten beweglichen Träger (22), welcher nach der ersten, der zweiten und der dritten Achse verschiebbar ist, und einen zweiten Träger (24) umfassen, welcher um die dritte Achse drehbar ist, auf dem ersten Träger befestigt ist und die Einrichtungen (46) zum Halten des Plättchens trägt.

8. Vorrichtung nach einem der Ansprüche 6 und 7, dadurch gekennzeichnet, daß das Werkzeug (30), das geeignet ist, den Eindruck zu erzeugen und den Strich anzureißen, mit der Beobachtungsoptik (28) fest verbunden ist, wobei die aus diesem Werkzeug und dieser Optik gebildete Anordnung in der Weise beweglich ist, daß man abwechselnd die Beobachtungsoptik und das Werkzeug in die Ziellinie (Z) stellen kann.

9. Vorrichtung nach einem der Ansprüche 6 bis 8, dadurch gekennzeichnet, daß die Einrichtungen, die geeignet sind, einen Strich zur Spaltung anzureißen, ein Anreißwerkzeug (40) umfassen, das unter genannten Trageeinrichtungen (22, 24) angeordnet ist und das parallel zur ersten (X), zweiten (Y) und dritten Achse verschiebbar ist, daß die Trageeinrichtungen eine Bohrung umfassen, die den Durchgang des Anreißwerkzeugs ermöglichen, und daß die Einrichtungen (46) zum Festhalten des Plättchens dazu geeignet sind, wenn das Anreißwerkzeug gegen das Plättchen drückt, dessen Aufstehen zu verhindern.

10. Vorrichtung nach einem der Ansprüche 5 bis 9, dadurch gekennzeichnet, daß die Ziellinie (Z) ferner mit Einrichtungen (58) zum Bestimmen mindestens einer Spaltungsrichtung versehen ist.

11. Vorrichtung nach einem der Ansprüche 6 bis 9, dadurch gekennzeichnet, daß das Werkzeug (30), das geeignet ist, den Eindruck zu erzeugen und den Strich anzureißen, dazu vorgesehen ist, einen Einschlag von sphärischer Form auf dem Plättchen zu erzeugen.

## Claims

1. Process for marking off a reference direction on a wafer of a microcrystalline semiconducting material having a hardness at the most equal to 500 KNOOP units and for cleaving the said wafer, comprising the following stages:
- forming an impression (1) on the so-called front or head face of the wafer (26), on which are or will subsequently be formed the semiconductor components (54) and in a so-called non-useful zone (52) of said front or head face and which does not or will not subsequently carry any of said components, the impression revealing on said non-useful zone at least one direction, whereof the reference direction (9, 11, 13) is deduced,
- said reference direction is marked by a line on the non-useful zone and
- the reference direction (9, 11, 13) corresponding to a direction along which it is possible to cleave the wafer, the latter being cleaved by making a cleaving line in the reference direction on the other rear face of the wafer and in a zone of said rear face located below said non-useful zone, so as to cleave the wafer in said non-useful zone provided for this purpose.

2. Process according to claim 1, characterized in that the wafer is made from a monocrystalline material from within the group CdTe, CdHgTe, InP, InSb, and AlGaAs.

3. Process according to either of the claims 1 and 2, characterized in that the direction revealed by the formation of the impression is parallel to the sliding planes (2, 4, 6) of the material, said material having cleaving planes (8, 10, 12) perpendicular to said sliding planes and in that the reference direction is perpendicular to the direction revealed by the formation of the impression.

4. Process according to any one of the claims 1 to 3, characterized in that the impression is formed by a member of the type used for microhardness tests on materials.

5. Device for marking off a reference direction onto a wafer (26) of a monocrystalline semiconductor material of limited hardness at the most equal to 500 KNOOP units and cleaving the said wafer, the reference direction (9, 11, 13) corresponding to a direction along which it is possible to cleave the wafer, said device comprising means (13a, 22, 24, 30) for the formation of an impression and for plotting provided for the formation of an impression on a so-called head face of the wafer and on which are or will subsequently be formed semiconductor components (54), and in a so-called non-useful zone (52) of said head face and which does not carry or will not subsequently carry any components, the impression revealing, on said non-useful zone, at least one direction from which is deduced the reference direction, for plotting, on the non-useful zone a line for marking said reference direction, said device also having means (40, 42, 44) able to make a cleaving line along the reference direction on the other or rear face of the wafer and in a zone of said rear face which is below said non-useful zone, so as to cleave the wafer in said non-useful zone provided for this purpose.

6. Device according to claim 5, characterized in that the impression forming and plotting means comprise means (22, 24) for supporting the wafer (26), the latter resting on said support means by the rear face, said support means being mobile in translation along a first axis (X) and a second axis (Y) perpendicular to the first axis, said support means also being mobile in rotation about a third axis (T), which is perpendicular to the first and second axes and mobile in translation parallel to said third axis, means (46) for maintaining the wafer on the support means, means (13a) for the microscopic observation of the front face of the wafer along a sighting axis (Z) parallel to the third axis (T) and provided with means (16) for locating the first and second axes, said observation means having at least one microscopic observation optics (28) and a member (30) able to form the impression and able to plot the line when the support means are displaced in translation along one of the first and second axes.

7. Device according to claim 6, characterized in that the support means comprise a first support (22) mobile in translation along the first, second and third axes and a second support (24) mobile in rotation about the third axis, which is mounted on the first support and which carries the wafer holding means (46).

8. Device according to either of the claims 6 and 7, characterized in that the member (30) for forming the impression and plotting the line is rendered integral with the observation optics (28), the assembly formed by said member and said optics being mobile in such a way that alternately the observation optics and the organ can be positioned along the sighting axis (Z).

9. Device according to any one of the claims 6 to 8, characterized in that the means able to plot or make a cleaving line comprise a plotting member (40) positioned below said support means (22, 24) and mobile in translation parallel to the first (X), second (Y) and third axes, in that the support means have an opening permitting the passage of the plotting member and in that the wafer holding means (46) are able to prevent the raising of the latter when the plotting member bears against it.

10. Device according to any one of the claims 5 to 9, characterized in that the sighting axis (Z) is also provided with means (58) for locating at least one cleaving direction.

11. Device according to any one of the claims 6 to 9, characterized in that the member (30) able to form the impression and plot the line serves to form a spherical impact on the wafer.
